# FASCICULE DE BREVET EUROPEEN

(11) **EP 0 493 208 B1**
(45) Date de publication et mention de la délivrance du brevet: **09.08.1995**
(21) Numéro de dépôt: 91403455.8
(22) Date de dépôt: 19.12.1991
(51) Int. Cl.: H01L 23/44, G01J 5/06, F25D 19/00

(54) **Doigt de refroidissement d'un circuit semi-conducteur et dispositif cryogénique pourvu d'un tel doigt**
Kühlfinger für Halbleiterschaltung und kryogenische Anordnung mit solchem Finger
Cold finger for semiconductor circuit and cryogenic device having such finger

(30) Priorité: 28.12.1990 FR 9016454
(43) Date de publication de la demande: 01.07.1992
(73) Titulaire: SAT (Société Anonyme de Télécommunications), 75116 Paris (FR)
(72) Inventeur: Langle, Patrick, F-91530 Val-Saint-Germain (FR); Langlet, Jean-Pierre, F-91450 Etiolles (FR); Loiseau, Joseph, F-94410 Saint Maurice (FR)
(74) Mandataire: Bloch, Gérard

(56) Documents cités:
- EP-A- 0 364 347
- EP-A- 0 372 108
- US-A- 4 344 302
- US-A- 4 950 181
- IBM TECHNICAL DISCLOSURE BULLETIN. vol. 18, no. 4, Septembre 1975, NEW YORK US pages 1226 - 1229; V.L. RIDEOUT: 'Close-cycle liquid nitrogen refrigeration system for low-temperature computer operation.'

## Description

La présente invention a tout d'abord pour objet un doigt creux de refroidissement d'un circuit semi-conducteur, dont la paroi délimite un volume intérieur destiné à recevoir un fluide cryogénique introduit par la base du doigt, et dont l'extrémité libre présente une face extérieure en contact thermique avec le circuit à refroidir.

Un tel doigt est utilisé notamment dans les cryostats destinés à maintenir un circuit semi-conducteur détecteur de rayonnement à une température de fonctionnement optimale, de valeur relativement basse. En particulier, un tel cryostat est utilisé pour les détecteurs infra-rouges qui sont utilisés pour la vision nocturne ou pour le guidage des missiles.

Dans les cryostats connus (voir le brevet EP-A-0 364 347 par exemple), le doigt est de forme cylindrique, au moins dans la partie voisine de son extrémité libre, et il est disposé dans une enceinte transparente au rayonnement à détecter, au moins dans la zone en regard du détecteur. Le vide est fait à l'intérieur de l'enceinte, pour isoler thermiquement le doigt et le milieu extérieur. Le détecteur, comprenant généralement une mosaïque de détecteurs élémentaires, convertit le rayonnement qu'il reçoit en signaux électriques amenés à l'extérieur de l'enceinte par des connexions traversant sa paroi de façon hermétique, en vue de leur exploitation.

Le fluide cryogénique qui sert à refroidir le volume intérieur du doigt peut être un gaz liquéfié comme de l'azote liquide simplement versé dans le doigt froid. Cependant ce mode de refroidissement est limité au laboratoire, et pour les systèmes opérationnels civils ou militaires, on préfère utiliser un fluide produit par une machine cryogénique. On connaît deux types de telles machines, d'une part les refroidisseurs à détente Joule-Thomson, d'autre part les refroidisseurs mécaniques à cycle fermé.

De façon bien connue de l'homme du métier, les refroidisseurs à détente Joule-Thomson utilisent la détente d'un gaz comprimé, en général de l'azote, pour le liquéfier. Le gaz comprimé circule d'abord dans un échangeur terminé par un diffuseur en sortie duquel il se détend. Après détente, le gaz repasse sur l'échangeur, à l'extérieur cette fois, ce qui produit un prérefroidissement du gaz comprimé qui se trouve à l'intérieur. Après une période transitoire, on obtient un jet de gaz liquide en sortie du diffuseur, qui baigne la zone intérieure de la paroi du doigt en regard de la face extérieure en contact thermique avec le détecteur. L'alimentation en gaz se fait en principe à l'aide de bouteilles et de vannes, mais le gaz détendu peut éventuellement être récupéré et recomprimé.

Toujours de façon connue, les refroidisseurs mécaniques à cycle fermé utilisent également un gaz, en général de l'hélium, comprimé et détendu au niveau de la zone froide. Ils absorbent de la chaleur à la température froide et la rejettent à la température chaude en contrepartie d'une dépense d'une certaine énergie fournie par un compresseur. Le fonctionnement se fait suivant un cycle thermodynamique déterminé.

Les doigts froids connus, que le fluide cryogénique qu'ils utilisent proviennent d'un refroidisseur à détente Joule-Thomson ou d'un refroidisseur mécanique à cycle fermé, présentent les inconvénients d'une mise en froid relativement lente en début de fonctionnement, de variations aléatoires de la température du détecteur en régime établi à l'origine d'un bruit électrique qui diminue la sensibilité du détecteur, et d'une consommation en fluide relativement importante en régime établi.

La présente invention vise à pallier ces inconvénients.

A cet effet, elle a pour objet un doigt de refroidissement du type défini ci-dessus, caractérisé par le fait qu'il comprend une première partie, adjacente à ladite face extérieure, dont la section transversale diminue en s'éloignant de ladite face extérieure.

Dans les cas pratiques les plus fréquents, où le doigt présente une symétrie de révolution autour de son axe, la partie à section variable est un tronc de cône et se présente donc comme un entonnoir lorsque le doigt est vertical et que son extrémité libre est vers le haut. Toutefois, il est possible d'envisager une forme en tronc de pyramide inversée, ou encore toute forme intermédiaire, avec un profil linéaire ou non.

Avec le doigt de l'invention, la mise en froid du détecteur, pour que l'ensemble de sa surface soit à température uniforme, est plus rapide que dans les dispositifs connus. En effet, la forme du doigt au voisinage de son extrémité libre agit à la manière d'une tuyère pour assurer une meilleure circulation du liquide et du gaz détendu, ce qui permet d'obtenir plus vite une répartition uniforme de la température de la paroi en regard du détecteur. La demanderesse a en effet observé que, dans les doigts connus, la forme cylindrique de l'extrémité libre du doigt est à l'origine de turbulences qui provoquent de fortes variations de pression et donc des variations de température aléatoires du détecteur, en début de fonctionnement comme en régime établi. La forme particulière du doigt, qui permet de réduire les turbulences du fluide cryogénique, a donc pour conséquence une température du détecteur plus basse et plus stable dans le temps comme dans l'espace.

Par ailleurs du fait que le doigt va en se rétrécissant en s'éloignant de la face en contact thermique avec le détecteur, la partie du doigt la plus proche de sa base est de dimensions transversales réduites. Dans le cas d'un doigt à symétrie de révolution, le diamètre de la partie du doigt la plus proche de sa base est ainsi sensiblement plus petit que le diamètre de la face en contact thermique avec le détecteur, alors que dans les systèmes connus, le diamètre de l'ensemble du doigt est égal au diamètre de la face en contact thermique avec le détecteur, face dont le diamètre est en principe égal à celui du détecteur. Or c'est dans la partie du doigt la plus proche de sa base que sont logés les organes du refroidisseur qui déterminent sa consommation en fluide, donc en énergie. Plus ces organes sont de faibles dimensions, plus la consommation en fluide est réduite.

Dans une forme de réalisation particulière, le fluide cryogénique est produit par un refroidisseur à détente Joule-Thomson, pourvu d'un échangeur logé dans une deuxième partie du doigt proche de sa base, et la section transversale de la deuxième partie, ainsi que la section transversale de l'échangeur augmentent progressivement en se rapprochant de la base du doigt.

Dans ce cas la surface d'échange à basse pression de l'échangeur se trouve augmentée, ce qui améliore l'efficacité de fonctionnement du refroidisseur Joule-Thomson.

Dans une autre forme de réalisation, le fluide cryogénique est produit par un refroidisseur à cycle fermé pourvu du échangeur disposé dans ledit volume et il est prévu une couche de gaz conducteur thermique entre ladite face extérieure et ledit échangeur.

Dans cette forme de réalisation, et avantageusement, ladite paroi est pourvue de rainures, dans sa partie qui correspond à ladite face extérieure, pour accroître la surface d'échange thermique avec ladite couche de gaz conducteur thermique.

Avantageusement encore, le gaz de ladite couche est de l'hélium, dont la conductivité thermique est particulièrement élevée.

Avantageusement toujours, ledit circuit comprend un détecteur de rayonnement infra-rouge, et il est prévu un diaphragme froid faisant partie intégrante de ladite première partie.

Un tel diaphragme froid permet de limiter le flux de photons engendré par le fond ambiant vu par le détecteur. L'intégration du diaphragme à la partie évasée permet de simplifier la fabrication et d'éliminer les soudures ou collages préjudiciables à la fiabilité de l'ensemble.

La présente invention a également pour objet un dispositif cryogénique caractérisé par le fait qu'il comprend un doigt de refroidissement du type défini ci-dessus.

La présente invention sera mieux comprise à la lecture de la description suivante de plusieurs formes de réalisation préférées du doigt et du dispositif cryogénique de l'invention, faite en se référant aux dessins annexés, sur lesquels :
- la figure 1 représente une vue en coupe simplifiée d'un cryostat,
- la figure 2 représente une vue en coupe simplifiée d'une première variante du doigt du cryostat de la figure 1,
- la figure 3 représente une vue en coupe simplifiée d'une deuxième variante du doigt du cryostat de la figure 1, et,
- la figure 4 représente une vue en coupe simplifiée d'une troisième variante du doigt du cryostat de la figure 1.

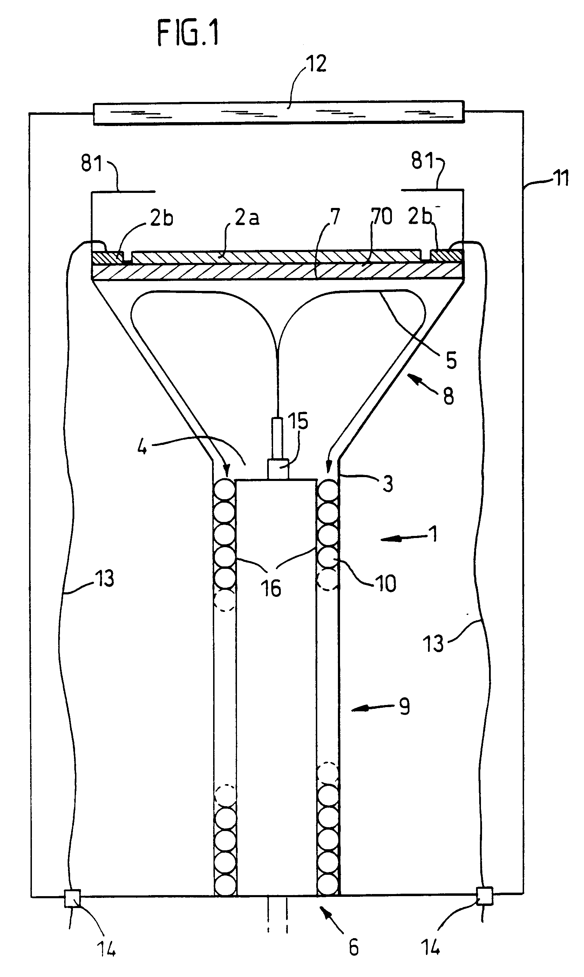

En se référant à la figure 1, un dispositif cryogénique, ici un cryostat, comprend une enceinte hermétique 11 à l'intérieur de laquelle est disposé un doigt creux de refroidissement 1, pour refroidir des circuits semiconducteurs 2a et 2b, en contact thermique avec une face extérieure 7 du doigt 1, qui constitue son extrémité libre.

Le contact thermique entre la face extérieure 7 et les circuits 2a et 2b est assuré ici par un plateau 70.

Le circuit 2a est une mosaïque de détecteurs élémentaires infra-rouges destinés à recevoir les rayonnements infra-rouges qui traversent une fenêtre 12 de l'enceinte 11, disposée en regard du circuit 2a. Les signaux électriques en sortie de chacun des détecteurs élémentaires infra-rouges du circuit 2a sont traités dans les circuits 2b notamment en vue de réduire le nombre des connexions 13 qui amènent les informations utiles hors de l'enceinte en vue de leur utilisation. Il est important de réduire le nombre des connexions 13 car chacune d'entre elles doit être munie d'une traversée étanche 14 et pose des problèmes d'encombrement. De plus, chaque connexion 13 est à l'origine de pertes thermiques susceptibles de rendre plus difficile le refroidissement de l'extrémité libre du doigt 1.

Le doigt 1 est formé d'une paroi 3 qui délimite un volume intérieur 4 qui reçoit un fluide cryogénique en sortie du diffuseur 15 d'un refroidisseur à détente Joule-Thomson.

Le corps du doigt 1 présente ici deux parties. Une première partie 8, adjacente à la face 7, présente la forme d'un tronc de cône dont la section transversale diminue progressivement en s'éloignant de la face 7. Une deuxième partie 9, cylindrique, s'étend depuis la base 6 du doigt jusqu'à l'extrémité, de section la plus faible, de la partie conique 8.

De façon connue, le refroidisseur à détente Joule-Thomson est pourvu d'un échangeur 10 comprenant un conduit enroulé en spirale contre la paroi 3 de la partie 9 du doigt 1.

Un diaphragme froid 81 fait partie intégrante de la partie conique 8, c'est-à-dire qu'il est réalisé en même temps et dans le même matériau que le doigt 1. Ce matériau est par exemple de l'acier inoxydable ou le matériau connu sous le nom de Kovar.

De façon connue, le diaphragme 81 a la forme d'une couronne qui masque la périphérie du détecteur 2a, et qui est reliée à l'extrémité la plus large de la partie conique 8 par l'intermédiaire d'une portion cylindrique.

Le dispositif qui vient d'être décrit fonctionne comme suit.

Le fluide cryogénique, ici de l'azote comprimé délivré par une bouteille non représentée, est introduit par la base 6 du doigt dans l'échangeur 10. Après avoir circulé dans l'échangeur 10, le gaz atteint le diffuseur 15 disposé dans la partie la plus étroite de la partie conique 8, et il se détend dans le volume intérieur de cette partie conique. Le gaz détendu est ensuite canalisé entre la paroi 3 et une paroi 16 pour circuler autour du conduit de l'échangeur 10, pour y refroidir le gaz comprimé qui circule à l'intérieur. Après une période transitoire, le diffuseur 15 délivre un jet d'azote liquide qui arrose toute la partie intérieure de la face d'extrémité 7. Comme cela a déjà été signalé, la forme conique de la partie 8 permet un écoulement laminaire et non turbulent du liquide éjecté, et un guidage des gaz détendus vers l'échangeur 10. De plus, cette forme permet d'avoir, au niveau de la face 7, une pression plus faible que celle au voisinage de l'entrée des gaz détendus dans l'échangeur 10, ce qui est favorable à un bon fonctionnement de l'ensemble.

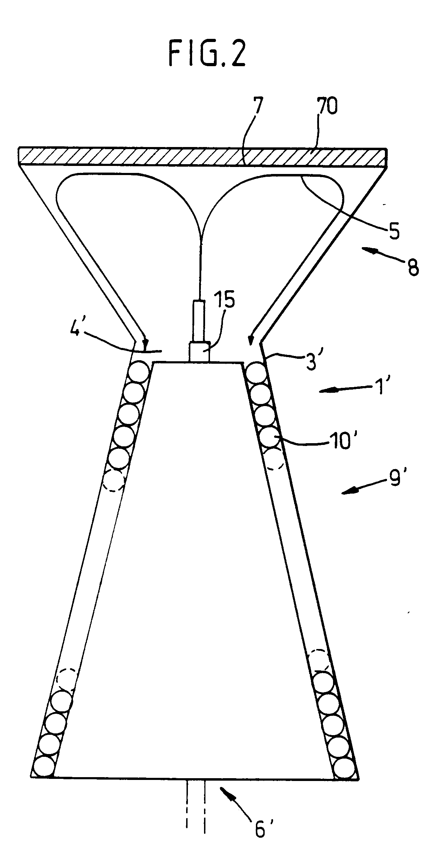

En référence à la figure 2, une variante 1′ du doigt 1 comprend une première partie 8 identique à la partie 8 du doigt 1, le diffuseur 15 arrosant la partie intérieure de la face 7, supportant le plateau porte-détecteur 70.

Une deuxième partie 9′, la plus proche de la base 6′ du doigt 1′, est de section transversale qui augmente progressivement en se rapprochant de la base 6′. Ici, la partie 9′ est un tronc de cône, et le doigt 1′ est donc formé de deux troncs de cône 8 et 9′ raccordés par leurs parties les plus étroites. Ceci permet de donner à l'échangeur 10′ une forme évasée comme la partie 9, augmentant ainsi la surface d'échange avec les gaz détendus, dans la zone où ceux-ci sont à pression relativement basse.

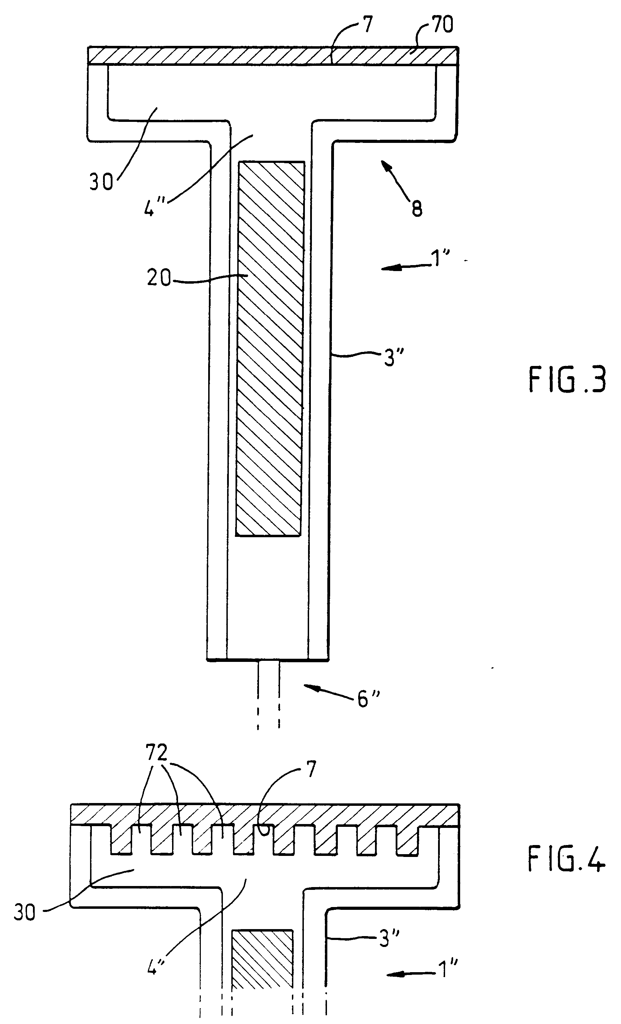

En référence maintenant à la figure 3, un doigt 1˝ refroidi à l'aide d'un refroidisseur mécanique à cycle fermé est maintenant décrit.

Comme cela a été signalé, un tel refroidisseur est une machine dans laquelle le refroidissement est obtenu à partir d'un cycle thermodynamique basé sur la compression et la décompression d'un gaz, notamment de l'hélium, à l'aide d'un échangeur thermique ou régénérateur.

Sur la figure 3, l'échangeur est désigné par la référence 20. Le doit 1˝ comprend toujours une première partie 8 adjacente à la face extérieure 7, dont la section transversale diminue en s'éloignant de cette face extérieure. Toutefois, en comparaison des formes des figures 1 et 2 s'évasant progressivement , la partie 8 du doigt de la figure 3 diminue d'une façon relativement brutale pour éviter de créer un volume conique trop important, se comportant comme un volume mort venant réduire le rendement et perturber le fonctionnement du refroidisseur.

Le volume entre la face extérieure 7 et l'échangeur 20 est rempli d'hélium qui forme ainsi une couche, dont la conductivité thermique élevée permet d'uniformiser la température du plateau 70. On pourrait utiliser, à la place de l'hélium, un autre gaz conducteur thermique.

L'évasement de la partie 8 n'est pas nécessairement aussi abrupt que sur la figure 3, et il est déterminé pour améliorer les échanges thermiques entre le plateau 70 sans dégrader le rendement thermodynamique du refroidisseur.

Comme le montre la figure 4, il est possible d'accroître la surface d'échange thermique entre la couche d'hélium occupant le volume 4˝ et la face extérieure 7, en pratiquant des rainures 72 dans la paroi 3˝ qui se trouve en regard,ou correspond, avec la face extérieure 7.

Naturellement, il est possible de prévoir un diaphragme froid sur le doigt 1˝ des figures 3 et 4, si cela est jugé utile.

## Revendications

1. Doigt creux (1, 1′, 1˝) de refroidissement d'un circuit semi-conducteur (2a, 2b), dont la paroi (3, 3′, 3˝) délimite un volume intérieur (4, 4′, 4˝) destiné à recevoir un fluide cryogénique (5) introduit par la base (6, 6′, 6˝) du doigt, et dont l'extrémité libre présente une face extérieure (7) en contact thermique avec ledit circuit (2a, 2b) à refroidir, caractérisé par le fait que ledit doigt comprend une première partie (8), adjacente à ladite face extérieure (7), dont la section transversale diminue en s'éloignant de ladite face extérieure (7).

2. Doigt selon la revendication 1, dans lequel le fluide cryogénique (5) est produit par un refroidisseur à détente Joule-Thomson, pourvu d'un échangeur (10′) logé dans une deuxième partie (9) du doigt proche de sa base (6′), et la section transversale de la deuxième partie (9′), ainsi que la section transversale de l'échangeur (10′) augmentent progressivement en se rapprochant de la base (6′) du doigt.

3. Doigt selon la revendication 1, dans lequel le fluide cryogénique est produit par un refroidisseur à cycle ferme pourvu d'un échangeur (20) disposé dans ledit volume (4˝) et il est prévu une couche (30) de gaz conducteur thermique entre ladite face extérieure (7) et ledit échangeur (20).

4. Doigt selon la revendication 3, dans lequel ladite paroi (3˝) est pourvue de rainures (72), dans sa partie qui correspond à ladite face extérieure (7) pour accroître la surface d'échange thermique avec ladite couche de gaz conducteur thermique.

5. Doigt selon l'une des revendications 3 et 4 dans lequel le gaz de ladite couche (30) est de l'hélium.

6. Doigt selon l'une des revendications 1 à 5, dans lequel ledit circuit comprend un détecteur (2a) de rayonnement infra-rouge, et il est prévu un diaphragme froid (81) faisant partie intégrante de ladite première partie (8).

7. Dispositif cryogénique caractérisé par le fait qu'il comprend un doigt selon l'une des revendications 1 à 6.

## Patentansprüche

1. Hohler Kühlzapfen (1, 1′, 1˝) für einen Halbleiterschaltkreis (2a, 2b), dessen Wandung (3, 3′, 3˝) ein Innenvolumen (4, 4′, 4˝) abgrenzt, welches zur Aufnahme eines Tieftemperaturfluids (5) bestimmt ist, das durch das Unterteil (6, 6′, 6˝) des Zapfens eingeleitet wird, und dessen freier Endabschnitt eine Außenseite (7) in thermischen Kontakt mit dem zu kühlenden Schaltkreis (2a, 2b) aufweist, dadurch gekennzeichnet, daß der Zapfen benachbart zur Außenseite (7) einen ersten Abschnitt (8) aufweist, dessen Querschnittsfläche mit zunehmendem Abstand von der Außenseite (7) abnimmt.

2. Kühlzapfen nach Anspruch 1, dadurch gekennzeichnet, daß das Tieftemperaturfluid (5) durch eine Joule-Thomson-Entspannungskühlvorrichtung geliefert wird, die mit einem Wärmetauscher (10′) versehen ist, welcher in einem zweiten Abschnitt (9) des Zapfens in der Nähe seines Unterteils (6) untergebracht ist, wobei der Querschnitt des zweiten Abschnitts (9′) sowie der Querschnitt des Wärmetauschers (10′) mit abnehmendem Abstand zum Unterteil (6′) des Zapfens allmählich zunehmen.

3. Kühlzapfen nach Anspruch 1, dadurch gekennzeichnet, daß das Tieftemperaturfluid durch eine Kühlvorrichtung mit geschlossenem Kreislauf erzeugt wird, die mit einem Wärmetauscher (20) versehen ist, welcher in dem Volumen (4˝) untergebracht ist, wobei zwischen der Außenseite (7) und dem Wärmetauscher (20) eine Schicht (30) thermisch leitenden Gases vorhanden ist.

4. Kühlfinger nach Anspruch 3, dadurch gekennzeichnet, daß die Wandung (3˝) in ihrem der Außenseite (7) entsprechendem Abschnitt mit Nuten (72) versehen ist, um die Oberfläche für den Wärmetausch mit der Schicht thermisch leitenden Gases zu vergrößern.

5. Kühlzapfen nach Anspruch 3 oder 4, dadurch gekennzeichnet, daß das Gas der Schicht (30) Helium ist.

6. Kühlzapfen nach einem der Ansprüche 1 bis 5, dadurch gekennzeichnet, daß die Schaltung einen Detektor (2a) für Infrarotstrahlung aufweist, wobei eine kalte Blende (81) vorhanden ist, die mit dem ersten Abschnitt (8) ein Teil bildet.

7. Tieftemperatureinrichtung, dadurch gekennzeichnet, daß sie einen Kühlzapfen nach einem der Ansprüche 1 bis 6 aufweist.

## Claims

1. Hollow finger (1, 1′, 1˝) for cooling a semi-conductor circuit (2a, 2b), whereof the wall (3, 3′, 3˝) defines an inner volume (4, 4′, 4˝) intended to receive a cryogenic fluid (5) introduced through the base (6, 6′, 6˝) of the finger, and whereof the free end has an outer face (7) in thermal contact with said circuit (2a, 2b) to be cooled, characterised by the fact that said finger comprises a first part (8), adjacent to said outer face (7), whereof the cross-section decreases moving away from said outer face (7).

2. Finger according to Claim 1, in which the cryogenic fluid (5) is produced by a cooler with Joule-Thomson expansion, provided with an exchanger (10′) housed in a second part (9) of the finger close to its base (6′) and the cross-section of the second part (9′), as well as the cross-section of the exchanger (10′) increase progressively on moving towards the base (6′) of the finger.

3. Finger according to Claim 1, in which the cryogenic fluid is produced by a cooler with a closed cycle provided with an exchanger (20) disposed in said volume (4˝) and a layer (30) of gas is provided, which is a thermal conductor between said outer face (7) and said exchanger (20).

4. Finger according to Claim 3, in which said wall (3˝) is provided with grooves (72), in its part which corresponds to said outer face (7) in order to increase the thermal exchange surface with said layer of gas which is a thermal conductor.

5. Finger according to one of Claims 3 and 4, in which the gas of said layer (30) is helium.

6. Finger according to one of Claims 1 to 5, in which said circuit comprises an infra-red radiation detector (2a) and a cold diaphragm (81) is provided forming an integral part of said first part (8).

7. Cryogenic device characterised by the fact that it comprises a finger according to one of Claims 1 to 6.
